# FASCICULE DE BREVET EUROPEEN

(11) **EP 0 694 958 B1**
(45) Date de publication et mention de la délivrance du brevet: **01.10.1997**
(21) Numéro de dépôt: 95401766.1
(22) Date de dépôt: 25.07.1995
(51) Int. Cl.: H01L 21/00

(54) **Appareil de chargement de plaquettes de semi-conducteur**
Ladungsvorrichtung für Halbleiter-Plättchen
Loading device for wafers

(30) Priorité: 29.07.1994 FR 9409484
(43) Date de publication de la demande: 31.01.1996
(73) Titulaire: SGS-THOMSON MICROELECTRONICS S.A., 94250 Gentilly (FR)
(72) Inventeur: Testa, Daniel, Cabinet Ballot-Schmit, F-94230 Cachan (FR)
(74) Mandataire: Schmit, Christian Norbert Marie

(56) Documents cités:
- US-A- 5 004 399
- US-A- 5 095 300

## Description

L'invention concerne un appareil de chargement de plaquettes de semi-conducteur. Il s'applique au domaine de fabrication de circuits intégrés semi-conducteur.

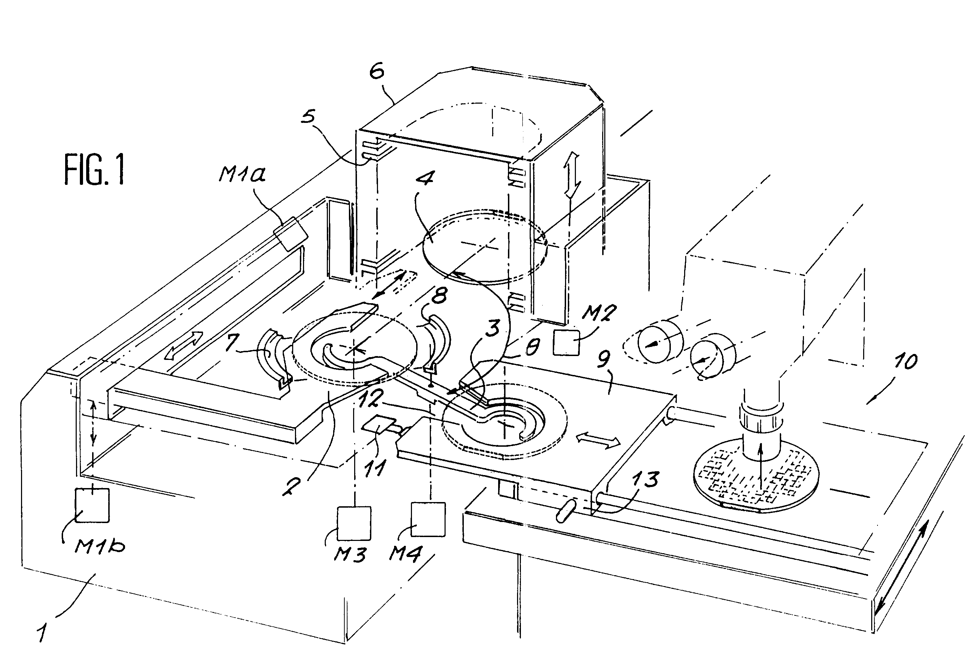

Un appareil de chargement de plaquettes de semi-conducteur est utilisé pour transférer une plaquette sur une table mobile d'un appareil effectuant des opérations sur la plaquette. Dans un exemple représenté sur la figure 1, il s'agit d'un appareil d'inspection et de détection de défauts par microscope.

L'appareil de chargement 1 comprend une platine de transfert 2 et un bras de chargement 3 pour manipuler une plaquette 4. Les plaquettes sont disposées dans des rainures de rangement 5 d'une cassette 6 à élévateur (moteur ascenseur M2).

Tous ces éléments mobiles (cassette, platine de transfert, bras de chargement) sont commandés électroniquement par un calculateur numérique non représenté sur cette figure.

Le bras de transfert se déplace en translation (moteur M1a) et verticalement (moteur M1b), pour sortir une plaquette d'une rainure de la cassette, et la déposer sur une platine de positionnement. Cette platine de positionnement comprend deux bords de serrage 7 et 8 commandés en coulissement pour bloquer la plaquette, et en rotation pour faire pivoter la plaquette (moteur M3). C'est ensuite le bras de chargement 3 qui effectue le transfert de la plaquette positionnée vers une table mobile 9 de l'appareil d'inspection par microscope 10. Cette table mobile en XY doit être amenée dans une position de transfert repérée sur l'appareil de chargement, par exemple par une butée 11, pour recevoir la plaquette amenée par le bras de chargement. Cette position de transfert en butée est testée électroniquement pour assurer la dépose des plaquettes.

Le bras de chargement peut subir deux types de déplacement (moteur M4) : déplacement vertical entre une position basse et une position haute et déplacement angulaire d'amplitude θ entre une position de repos et la platine de positionnement.

La position haute du bras de chargement est plus haute et la position basse, plus basse que la platine de positionnement portant la plaquette positionnée. Le bras de transfert a une forme de demi-cercle permettant le passage du bras de chargement en position basse, quand il vient se placer sous la platine de positionnement pour prendre la plaquette positionnée.

Ainsi, pour déposer une plaquette sur la table mobile, le bras de chargement doit d'abord être actionné pour aller chercher la plaquette. Il effectue un mouvement rotationnel en position basse d'un angle θ (moteur M4) vers l'axe de translation linéaire du bras de transfert pour se placer sous la plaquette positionnée, puis un mouvement ascensionnel pour passer de la position basse en position haute (moteur M4) et prendre la plaquette au passage. La plaquette est alors maintenue sur le bras de chargement, par aspiration. Le bras de chargement qui est toujours en position haute, effectue le mouvement rotationnel inverse (θ) vers sa position de repos, puis repasse en position basse, déposant au passage la plaquette sur la table mobile 9 qui aura été mise en position de transfert. Cette table mobile comporte en effet une découpe 12 pour laisser passer le bras porteur de sa position haute, plus haute que la table, dans sa position basse, plus basse que la table. La table mobile de l'appareil d'inspection peut alors être déplacée et positionnée sous le microscope (table portée par un chariot 13 coulissant en X et en Y).

Un tel appareil de chargement utilisé dans une chaîne de fabrication doit pouvoir suivre une cadence importante, par exemple de l'ordre de 300 à 400 chargements de plaquettes sur une table de transfert par heure. Il doit aussi être très fiable, la manipulation des plaquettes de semi-conducteur nécessitant beaucoup de précaution.

Or, en pratique, on se trouve confronté à des problèmes de blocage de l'appareil de chargement des plaquettes. Ces blocages se produisent fréquemment, à n'importe quel moment du mode opératoire, et ils entraînent l'immobilisation complète des différents éléments.

Il faut alors couper la tension d'alimentation pour débloquer l'appareil, ce qui a pour effet de réinitialiser toute l'électronique de l'appareil de chargement et en particulier l'électronique de commande du bras de chargement. Le bras de chargement retourne alors brutalement en position de repos, en position basse.

Or, on a vu dans la description du fonctionnement de l'appareil que la table mobile de l'appareil d'inspection n'est pas nécessairement en position de transfert au moment du blocage : elle peut être n'importe où dans le plan XY entre le microscope et l'appareil de chargement. En particulier, la découpe de la table pour laisser passer le bras de chargement peut donc être désalignée par rapport à la position de repos de ce bras. Le bras de chargement peut alors tomber sur la table et se tordre. La table peut aussi être endommagée et la fiabilité de l'appareil de chargement être affectée.

En pratique, c'est un problème qui immobilise plusieurs fois par jour ces appareils et oblige à avoir une maintenance (remplacement de pièces, immobilisation du matériel) qui rend coûteuse l'utilisation de ces appareils. Ceci est incompatible avec les grandes séries à traiter dans une chaîne de fabrication industrielle.

L'invention se propose de résoudre ce problème technique.

On a en effet pensé qu'il faudrait pouvoir ne pas couper le secteur, mais prévoir un circuit de réinitialisation qui pourrait prendre en compte la position de la table mobile pour n'autoriser la réinitialisation de l'électronique de commande du bras de chargement que s'il ne risque pas de tomber sur la table.

Selon l'invention, on utilise alors une information de position de la table mobile pour autoriser ou non la réinitialisation électronique de la commande du bras de chargement.

L'invention peut être utilisée pour toutes les applications de transfert de plaquettes, et n'est pas limitée à l'exemple explicité ici d'inspection et de détection des défauts des plaquettes par microscope.

Telle qu'elle est caractérisée, l'invention concerne un appareil de chargement de plaquettes de semi-conducteur sur une table mobile au moyen d'un bras de chargement commandé électroniquement. Selon l'invention, cet appareil de chargement comprend un circuit électronique de réinitialisation de la commande électronique du bras, comportant un circuit de prise en compte d'un signal de détection de position de la table mobile.

Avantageusement, on choisit une position de la table mobile qui est connue de l'appareil de chargement, la position de transfert. Dans cette position de transfert, on est sûr que ni le bras, ni la table ne seront endommagés quand le bras retombe en position de repos.

D'autres caractéristiques et avantages de l'invention sont présentés dans la description qui suit, faite à titre indicatif et non limitatif de l'invention et en référence aux dessins annexés dans lesquels :
- la figure 1 déjà décrite représente un appareil de chargement de plaquettes de semi-conducteur utilisé avec un appareil d'inspection des plaquettes par microscope et
- la figure 2 représente un schéma d'un circuit électronique de commande d'un appareil de chargement comprenant un circuit d'initialisation selon l'invention.

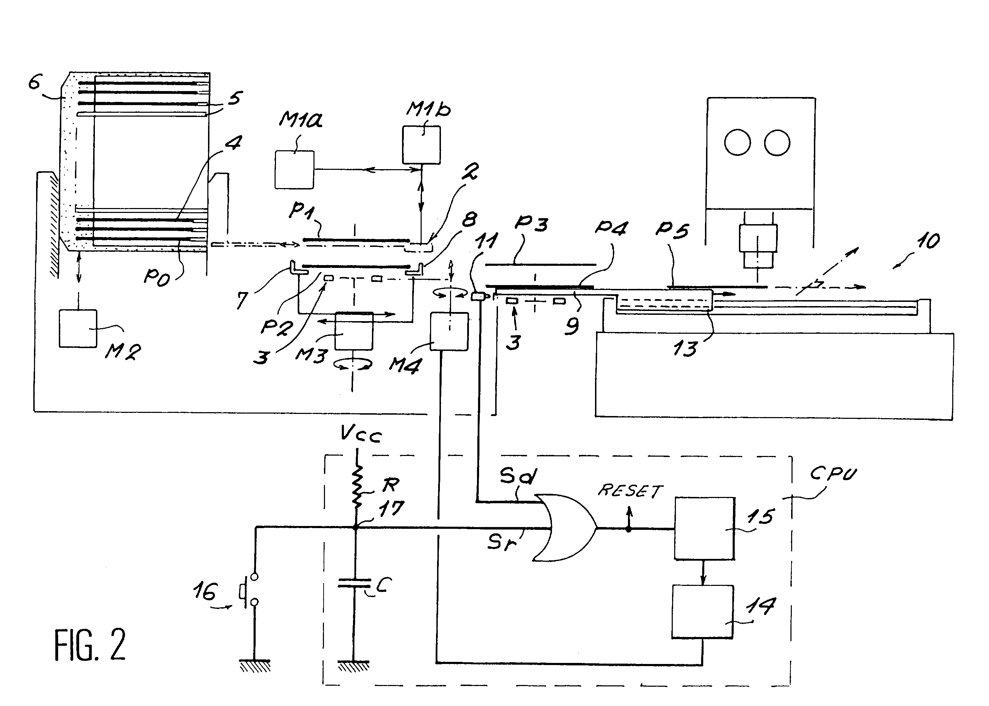

La figure 2 représente schématiquement l'appareil de chargement de plaquette en vue de profil et l'appareil d'inspection par microscope déjà décrit en référence à la figure 1.

En particulier, la cassette 6 comportant les plaquettes 4, le bras de transfert 2, la platine de positionnement (7,8), le moteur de déplacement en élévation et rotation (M4) du bras de chargement sont représentés. Le chemin suivi par les plaquettes est illustré sur la figure par les positions P0 à P5 successives.

Un calculateur numérique CPU commande électroniquement ces différents éléments. Notamment, il comprend un circuit 14 de commande du moteur de déplacement du bras de chargement et un circuit électronique 15 d'asservissement de position (à microprocesseur) qui pilote ce circuit de commande.

Selon l'invention, le calculateur numérique comprend en outre un circuit de réinitialisation de la commande électronique du bras de chargement, comportant un circuit de prise en compte d'un signal de détection Sd de position de la table mobile.

Ainsi, si on commande la réinitialisation de la commande électronique du bras de chargement, elle ne sera prise en compte que si la table mobile 9 est dans une position permettant le retour du bras de chargement en position de repos sans risques de détérioration pour le bras ou pour la table.

Avantageusement et comme représenté, on choisit que cette position de la table autorisant la réinitialisation est la position de transfert, repérée par exemple par un contact mécanique 11.

On peut aussi repérer la position de transfert par d'autres modes de détection, par exemple en utilisant un détecteur à diode électroluminescente.

On pourrait choisir une position de la table, telle que le bras de chargement ne puisse la toucher en retombant, c'est à dire suffisamment éloignée. Cette solution est cependant moins intéressante, obligeant à utiliser un système plus complexe de détection, par exemple à détecteur de distance.

Le circuit de réinitialisation comporte un contacteur 16 de commande de réinitialisation actionnable manuellement avec un circuit de mise en forme du signal comportant dans l'exemple une résistance R et un condensateur C en série entre une tension d'alimentation Vcc et la masse, le contacteur étant connecté au point milieu 17 entre la résistance et le condensateur.

Le point milieu est alors à un niveau de tension logique haut, correspondant à un "1" logique, imposé par le condensateur chargé. Quand le contacteur est actionné, le condensateur se décharge via le contacteur et amène le point milieu à un niveau de tension nul, correspondant à un zéro logique.

Le circuit de prise en compte du signal de détection de prise en compte de position de la table est un circuit logique conditionnel qui reçoit en entrée le signal Sr fourni par le point milieu 17 et le signal de détection Sd de prise en compte de la position de la table. Ce dernier est fourni par le détecteur de position 11. Dans le cas représenté d'un détecteur à contact mécanique, il comprend un circuit de prise en compte de contact, par exemple de même type que celui que l'on vient de décrire. Si ce détecteur fournit un zéro quand la table est positionnée et un "1" logique quand la table n'est pas positionnée, le circuit de prise en compte comprendra par exemple une porte logique "ou" recevant les deux signaux et délivrant le signal de réinitialisation conditionnel noté RESET. Ce signal RESET est appliqué à l'électronique de commande du bras de chargement.

De préférence, il est appliqué au calculateur numérique, qui réinitialise tous ses circuits électroniques.

## Revendications

1. Appareil de chargement de plaquettes de semi-conducteur (1) sur une table mobile (2) au moyen d'un bras (3) commandé électroniquement, caractérisé en ce qu'il comprend un circuit électronique de réinitialisation de la commande électronique du bras comportant un circuit de prise en compte d'un signal de détection (Sd) de position de la table mobile qui n'autorise la réinitialisation que lorsque la table mobile se trouve dans une position dans laquelle le retour du bras (3) dans sa position de repos, lors de la réinitialisation, est possible sans risque de détérioration mécanique du bras.

2. Appareil de chargement de plaquettes selon la revendication 1, caractérisé en ce que la position de la table mobile est une position permettant la dépose de plaquettes.

3. Appareil de chargement de plaquettes selon la revendication 2, caractérisé en ce que le signal de détection est fourni par un détecteur mécanique.

4. Appareil de chargement de plaquettes selon la revendication 2, caractérisé en ce que le signal de détection est fourni par un détecteur à diode électroluminescente.

5. Appareil de chargement de plaquettes selon l'une quelconque des revendications précédentes, caractérisé en ce que le circuit de prise en compte est un circuit à portes logiques recevant en entrées, le signal de détection(Sd)et un signal(Sr)issu d'un contacteur manuel.

## Patentansprüche

1. Vorrichtung zum Laden von Halbleiter-Wafern (1) auf einen beweglichen Tisch (2) mittels eines elektronisch gesteuerten Arms (3), gekennzeichnet durch eine elektronische Schaltung zum Reinitialisieren der elektronischen Steuerung des Arms, die eine Schaltung zum Berücksichtigen eines die Position des beweglichen Tischs angebenden Erfassungssignals (Sd) umfaßt, die die Reinitialisierung nur dann freigibt, wenn sich der bewegliche Tisch in einer Position befindet, in der bei der Reinitialisierung die Rückkehr des Arms (3) in seine Ruhelage ohne Gefahr der mechanischen Beschädigung des Arms möglich ist.

2. Vorrichtung zum Laden von Wafern nach Anspruch 1, dadurch gekennzeichnet, daß die Position des beweglichen Tischs eine Position ist, die das Ablegen der Wafer erlaubt.

3. Vorrichtung zum Laden von Wafern nach Anspruch 2, dadurch gekennzeichnet, daß das Erfassungssignal durch einen mechanischen Detektor geliefert wird.

4. Vorrichtung zum Laden von Wafern nach Anspruch 2, dadurch gekennzeichnet, daß das Erfassungssignal durch einen Elektrolumineszenzdioden-Detektor geliefert wird.

5. Vorrichtung zum Laden von Wafern nach einem der vorangehenden Ansprüche, dadurch gekennzeichnet, daß die Berücksichtigungsschaltung eine Logiktor-Schaltung ist, die eingangsseitig das Erfassungssignal (Sd) und ein von einem manuellen Kontaktgeber ausgegebenes Signal (Sr) empfangen.

## Claims

1. Appliance for loading semiconductor wafers (1) onto a movable table (2) by means of an electronically controlled arm (3), characterised in that it comprises an electronic circuit for reinitialising the electronic control of the arm including a circuit for acknowledging a signal (Sd) for detecting the position of the movable table which enables the initialisation only when the movable table is in a position in which the return of the arm (3) into its idle position, at the time of reinitialisation, is possible without risk of mechanical damage to the arm.

2. Appliance for loading wafers according to Claim 1, characterised in that the position of the movable table is a position enabling the wafers to be deposited.

3. Appliance for loading wafers according to Claim 2, characterised in that the detection signal is supplied by a mechanical detector.

4. Appliance for loading wafers according to Claim 2, characterised in that the detection signal is supplied by a detector with a light emitting diode.

5. Appliance for loading wafers according to any one of the preceding claims, characterised in that the acknowledgement circuit is a circuit with logic gates receiving as inputs the detection signal (Sd) and a signal (Sr) coming from a manual contactor.
